(19)

Europäisches Patentamt
European Patent Office
Office européen des brevets

(11) Veröffentlichungsnummer : **0 441 155 B1**

(12) # EUROPÄISCHE PATENTSCHRIFT

(45) Veröffentlichungstag der Patentschrift : **26.07.95 Patentblatt 95/30**

(51) Int. Cl.[6] : **H03H 17/06,** G11B 20/10

(21) Anmeldenummer : **91100652.6**

(22) Anmeldetag : **21.01.91**

(54) **Verfahren und Vorrichtung zum Umwandeln von Abtastfrequenzen.**

(30) Priorität : **07.02.90 CH 395/90**

(43) Veröffentlichungstag der Anmeldung : **14.08.91 Patentblatt 91/33**

(45) Bekanntmachung des Hinweises auf die Patenterteilung : **26.07.95 Patentblatt 95/30**

(84) Benannte Vertragsstaaten : **AT BE CH DE FR GB IT LI**

(56) Entgegenhaltungen :
**EP-A- 0 176 946**
**FERNSEH UND KINO TECHNIK. vol. 36, no. 10, Oktober 1982, BERLIN DE Seiten 397 -400; R. LAGADEC: "Digitaler Abtastenwandler für die professionelle Digital-Audiotechnik"**

(56) Entgegenhaltungen :
**AES, PRESENTED AT THE 76TH CONVENTION 8 Oktober 1984, NEW YORK Seiten 1 - 12; R. LAGADEC: "A new approach to sampling rate synchronization "**
**PROCEEDINGS OF THE IEEE vol. 61, no. 6, Juni 1973, Seiten 692 - 702; R.W. SCHAFER et al.: "A digital signal processing approach to interpolation"**

(73) Patentinhaber : **STUDER Professional Audio AG**
**Althardstrasse 30**
**CH-8105 Regensdorf ZH (CH)**

(72) Erfinder : **Pelloni, Daniele, Dr.**
**Naglerwiesenstrasse 88**
**CH-8049 Zürich (CH)**

(74) Vertreter : **Ellenberger, Maurice**
**STUDER Professional Audio AG**
**CH-8105 Regensdorf (CH)**

EP 0 441 155 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die Erfindung betrifft ein Verfahren und eine Vorrichtung zum Umwandeln der Abtastwerte einer Eingangsabtastfolge, die mit einer Eingangsabtastfrequenz auftreten, in Abtastwerte einer Ausgangsabtastfolge, die mit einer Ausgangsabtastfrequenz auftreten.

Ein solches Verfahren ist beispielsweise im europaeischen Patent Anmeldung EP-A-0 052 847 beschrieben. Gemaess diesem Verfahren lassen sich Abtastfolgen in Abtastfolgen mit beliebigen anderen Abtastfrequenzen ueberfuehren. Dabei werden gesuchte Abtastwerte durch Interpolation zwischen gegebenen Abtastwerten ermittelt. Diese Interpolationen werden in Interpolationsfiltern durchgefuehrt.

Mit einem solchen Verfahren sind aber verschiedene Nachteile verbunden. Einmal wird dabei Rauschen im Betrage von mindestens 3db erzeugt. Dies ist der Multiplikation der Eingangsabtastwerte mit den Filterkoeffizienten mit anschliessender Verkuerzung der so entstandenen Filterwortlaengen zuzuschreiben. Weiter wird die Qualitaet des Ausgangssignales vermindert wenn die Eingangsabtastfrequenz und die Ausgangsabtastfrequenz nicht in optimaler Qualitaet vorliegen. Dies kann beispielsweise durch Phasenregelschaltungen (PLL) ungenuegender Qualitaet verschuldet sein. Weiter kann der Aufwand fuer die Speicherung von Filterkoeffizienten und die notwendige Logik fuer deren Verarbeitung betraechtlich sein, wenn die Ein- und Ausgangsabtastfrequenzen bestimmte Voraussetzungen erfuellen.

Die Erfindung, wie sie in den Patentanspruechen gekennzeichnet ist, loest die Aufgabe ein solches Verfahren zu schaffen, bei dem die genannten Nachteile mindestens teilweise entfallen und das einfacher arbeitet und mit einfacheren Mitteln zu realisieren ist.

Bei der Erfindung wird dies erreicht, indem in einer Stufe eine Wandlung zwischen Abtastfolgen mit nominal gleichen oder beinahe gleichen Abtastfrequenzen durchgefuehrt wird, wobei die beiden Abtastfolgen zueinander synchronisiert werden. Ein solches Verfahren ist beispielsweise im europaeischen Patent Anmeldung EP-A-0 176 946 beschrieben. In einer anderen Stufe wird die eine der Abtastfolgen in eine Abtastfolge mit ganz anderer Abtastfrequenz umgewandelt und zwar mit einem festen Verhaeltnis der beiden Abtastfrequenzen. Beide Stufen werden nacheinander und in beliebiger Reihenfolge durchlaufen.

Die durch die Erfindung erreichten Vorteile sind insbesondere darin zu sehen, dass die vorgeschlagene Loesung in den meisten Faellen angewendet werden kann. In besonderen Faellen, d.h. bei bestimmten Verhaeltnissen der Eingangsabastfrequenz zur Ausgangsabtastfrequenz fuehrt die Erfindung dazu, dass besonders einfache Loesungen verwendet werden koennen. Insbesondere kann derjenige Teil der Vorrichtung, der die Abtastfrequenzen in einem festen Verhaeltnis umwandelt, sehr einfach ausgestaltet werden. Auch ist die Qualitaet der Taktsignale bei dieser Loesung nicht mehr von grosser Bedeutung fuer ein gutes Resultat bei der Wandlung. In vielen Faellen wird auch das oben erwaehnte Rauschen nicht mehr erzeugt werden.

Im folgenden wird die Erfindung anhand von lediglich einen Ausfuehrungsweg darstellenden Zeichnungen naeher erlaeutert. Es zeigt

Figur 1 verschiedene Abtastfolgen zeitlich gesehen,
Figur 2 und 3 spezielle Vorgaenge bei den Abtastfolgen aus Figur 1,
Figur 4 und 5 in schematischer Darstellung Ausschnitte aus verschiedenen Abtastfolgen,
Figur 6 eine schematische Darstellung einer Verarbeitungseinheit fuer die Abtastfolgen,
Figur 7 eine schematische Darstellung einer Vorrichtung zur Durchfuehrung des Verfahrens und
Figur 8 einen Teil der Vorrichtung nach Figur 7.

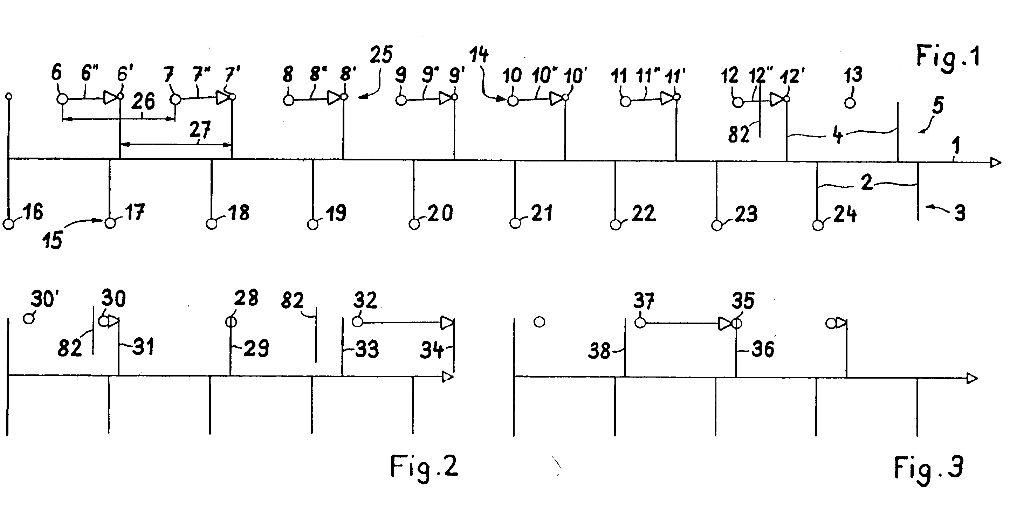

Die nachfolgend beschriebenen Figuren zeigen das zweistufige Verfahren unter der Annahme, dass zuerst eine Synchronisation der Abtastfolgen und anschliessend eine Umwandlung der Abtastfrequenzen erfolgt. In Figur 1 sind laengs einer Zeitachse 1 Abtastzeiten 2 einer Ausgangsabtastfrequenz 3 und Abtastzeiten 4 einer weiteren Abtastfrequenz 5 aufgetragen. Man erkennt ferner Abtastwerte 6 bis 13 einer Eingangsabtastfolge 14, wobei hier nicht die Groesse oder der Wert der Abtastwerte sondern nur die Zeit zu der sie anfallen interessieren. Mit 6′ bis 12′ sind die entsprechenden aber hier beispielsweise synchronisierten Abtastwerte einer weiteren Abtastfolge 25 bezeichnet. Ferner sind auch im gleichen Sinne die Abtastwerte einer Ausgangsabtastfolge 15 erkennbar, die mit 16 bis 24 bezeichnet sind und die mit der Ausgangsabtastfrequenz 3 zu Abtastzeiten 2 auftreten. Mit 6″ bis 12″ sind Pfeile bezeichnet, die Zeitdifferenzen zwischen den Abtastwerten 6 und 6′, 7 und 7′ usw. der Eingangsabtastfolge 14 und der weiteren Abtastfolge 25 darstellen. Zwischen den Eingangsabtastwerten 6 und 7 ist ein Abstand 26 und zwischen den weiteren Abtastwerten 6′ und 7′ ist ein Abstand 27 eingetragen.

In Figur 2 ist ein Ausschnitt aus der Darstellung nach Figur 1 fuer ein anderes Zeitfenster gezeigt. Darin trifft ein Eingangsabtastwert 28 gerade mit der weiteren Abtastzeit 29 zusammen. Da fuer dieses Zeitfenster die Eingangsabtastfrequenz gerade etwas tiefer ist als die weitere Abtastfrequenz, liegt der vorausgehende Eingangsabtastwert 30 noch gerade vor der Abtastzeit 31. Bei der Synchronisation der Eingangsabtastfolge mit der weiteren Abtastfolge wird der Eingangsabtastwert 30 somit verzoegert, bis er mit der naechsten Abtastzeit 31 zusammenfaellt. Der nachfolgende Eingangsabtastwert 32 der eigentlich einer Abtastzeit 33 zuzuordnen waere, liegt aber bereits jenseits dieser Abtastzeit 33, so dass er normalerweise bis zur Abtastzeit 34 verzoegert wird. Damit fehlt ein Abtastwert fuer die Abtastzeit 33.

In Figur 3 ist ein weiteres Zeitfenster wie in Figur 2 gezeigt. Darin trifft ein Eingangsabtastwert 35 gerade mit einer weiteren Abtastzeit 36 zusammen. Da fuer dieses Zeitfenster die Eingangsabtastfrequenz gerade etwas hoeher ist als die weitere Abtastfrequenz, liegt der vorausgehende Eingangsabtastwert 37 gerade nach der Abtastzeit 38. Bei der Synchronisation wird der Eingangsabtastwert 37 verzoegert, bis er mit der Abtastzeit 36 zusammenfaellt. Damit fallen auf die Abtastzeit 36 zwei Eingangsabtastwerte 35 und 37.

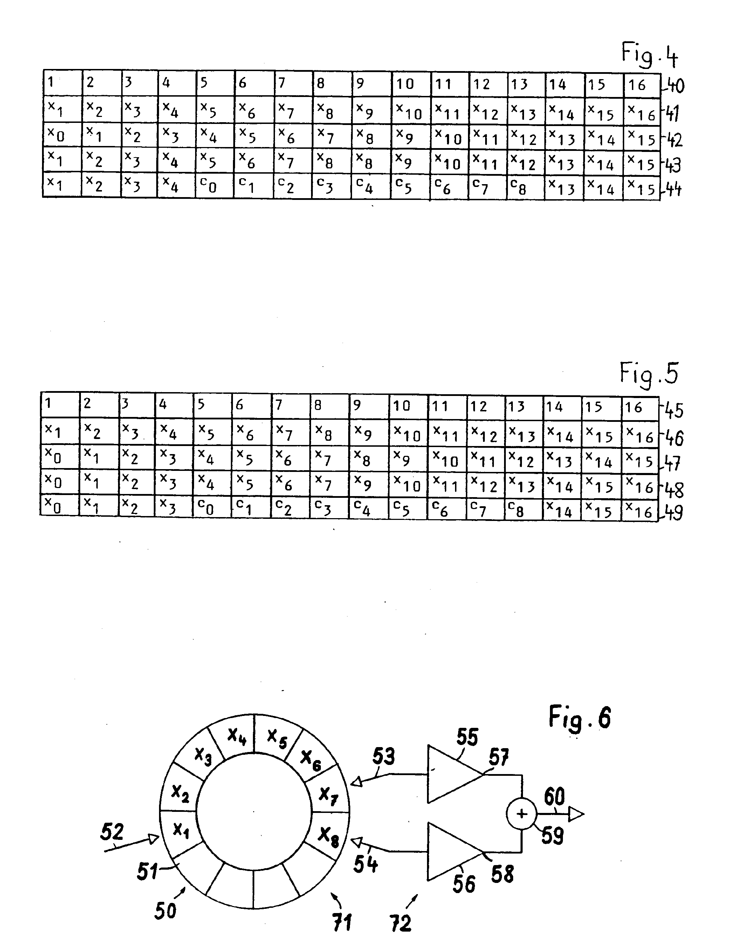

Figur 4 zeigt schematisch Ein- und Ausgangsabtastfolgen mit ihren Werten in einem bestimmten Zeitfenster. Dieses Zeitfenster enthaelt Takte, die mit 1 bis 16 numeriert sind und die in der Zeile 40 aufgefuehrt sind. Zeile 41 enthaelt die Werte $x_1$ bis $x_{16}$ einer weiteren Abtastfolge. Zeile 42 zeigt entsprechende Werte einer um ein Abtastintervall verzoegerten weiteren Abtastfolge. Zeile 43 enthaelt Werte einer Ausgangsabtastfolge die nach einem bekannten aber nicht nach dem erfindungsgemaessen Verfahren erzeugt ist. Zeile 44 enthaelt Werte einer Ausgangsabtastfolge, die nach dem erfindungsgemaessen Verfahren erzeugt ist.

Figur 5 zeigt genau die gleichen Folgen von Werten wie Figur 5, wenn auch teilweise mit anderen Werten. Zeile 45 entspricht dabei Zeile 40 aus Figur 4, Zeile 46 entspricht Zeile 41, Zeile 47 entspricht Zeile 42, Zeile 48 entspricht Zeile 43 und Zeile 49 entspricht Zeile 44. Die Bedeutung der einzelnen Werte wird nachfolgend behandelt werden.

Figur 6 zeigt in schematischer Darstellung einen ringfoermigen Speicher 50 mit Speicherplaetzen 51 die hier teilweise mit Abtastwerten $x_1$ bis $x_8$ belegt sind. Dabei hat die Ringform des Speichers nichts mit seiner wirklichen Form, dafuer aber mit seinem Arbeitsprinzip zu tun und dient der anschaulicheren Erklaerung der Ein- und Auslesevorgaenge. Zum Einlesen ist ein Einlesezeiger 52 und zum Auslesen sind zwei Auslesezeiger 53 und 54 vorgesehen, die so angeordnet sind, dass sie benachbarte Abtastwerte auslesen koennen. Bei dieser fuer die Vorstellung guenstigen Anordnung, sind alle Zeiger auf dem Speicher 50 verschiebbar oder ein Zeiger (oder Zeigerpaar) ist fest und der Speicher 50 ist drehbar zu denken. In Wirklichkeit entspricht einem Zeiger eine Einrichtung zum Erzeugen von Speicheradressen und im Speicher bewegt sich ausser Stroemen nichts. Die beiden Auslesezeiger 53 und 54 oder Ausgaenge 53, 54 sind je an eine Multipliziereinheit 55, 56 angeschlossen, deren Ausgaenge 57 und 58 in eine Addiervorrichtung 59 muenden, die wiederum einen Ausgang 60 hat.

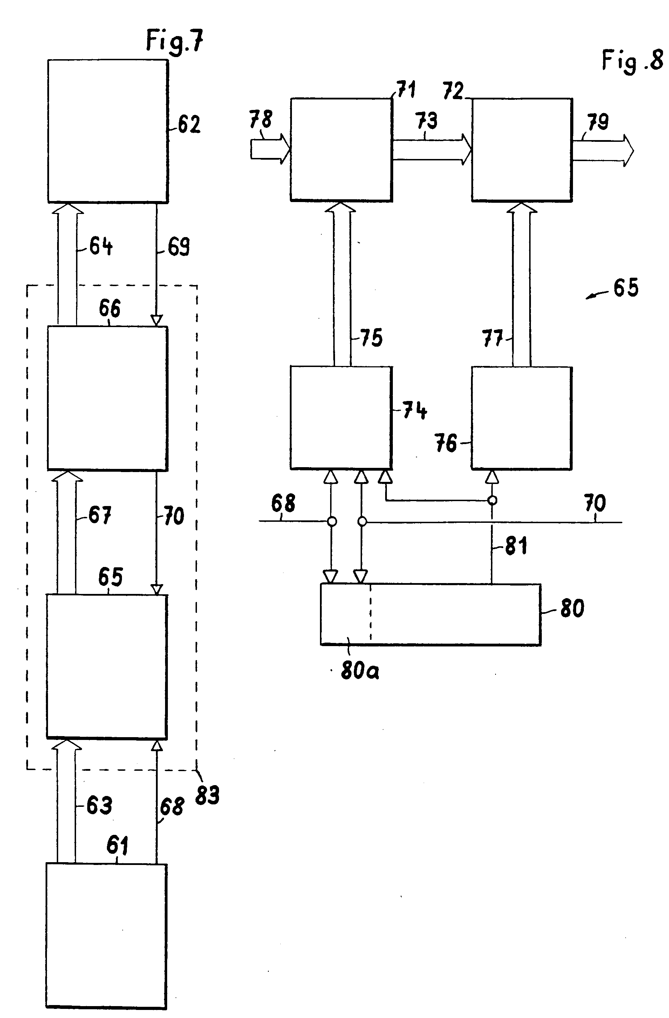

Figur 7 zeigt eine Blockschaltung einer Vorrichtung 83 zur Durchfuehrung des erfindungsgemaessen Verfahrens. Diese ist einerseits an eine Datenquelle 61 und andererseits an einen Verbraucher 62 ueber je einen Datenbus 63 und 64 angeschlossen. Als Datenquelle ist beispielsweise ein CD-Spieler denkbar, der Abtastwerte mit einer Abtastfrequenz von 44.1+E oder 44.1-E kHz abgibt (E=Abweichung). Als Verbraucher ist ein digital arbeitendes Studio oder Mischpult denkbar, das mit einer Abtastfrequenz von genau 48 kHz arbeitet. Die Vorrichtung 83 dazwischen ist in eine Synchronisierschaltung 65 und einen Abtastratenwandler 66 aufgeteilt. Beide sind ueber einen Datenbus 67 miteinander verbunden. Zur Uebertragung der Abtastfrequenzen sind Leitungen 68, 69 und 70 vorgesehen. In der Vorrichtung 83 koennen die Synchronisierschaltung 65 und der Abtastratenwandler 66 auch vertauscht sein.

Figur 8 zeigt einen moeglichen Aufbau fuer eine Synchronisierschaltung 65. Diese besteht aus einem Speicher 71 und einem Rechner oder Filter 72, die ueber einen Bus 73 miteinander verbunden sind. An den Speicher 71 ist ein Adressgenerator 74 ueber einen Adressbus 75 angeschlossen. An den Rechner 72 ist ein Koeffizientengenerator 76 ueber einen Bus 77 angeschlossen. Ein Eingangsbus 78 ist an den Speicher 71 und ein Ausgangsbus 79 ist an den Rechner 72 angeschlossen. Eine Steuereinheit 80 ist ferner ueber eine Steuerleitung 81 mit dem Koeffizientengenerator 76 und mit dem Adressgenerator 74 verbunden. Zudem sind die bekannten Leitungen 70 und 68 sowohl an die Steuereinheit 80 als auch an den Adressgenerator 74 angeschlossen.

Fuer die Durchfuehrung des Verfahrens steht eine Eingangsabtastfolge 14 mit Abtastwerten 6 bis 13 (Fig. 1) zur Verfuegung. Damit ist auch die Eingangsabtastfrequenz bekannt. Ferner steht eine Taktfrequenz zur Verfuegung, naemlich die gewuenschte Ausgangsabtastfrequenz 3 fuer die Ausgangsabtastfolge 15, wie sie beispielsweise ein Verbraucher 62 (Fig. 7) abgeben kann. Diese beiden Abtastfrequenzen werden kontinuierlich ueber die Leitungen 68, 69 und 70 (Fig. 7, 8) der Synchronisierschaltung 65 zugefuehrt. Dessen Steuereinheit 80 kann beispielsweise zusaetzlich einen Rechnerteil 80a aufweisen, der die weitere Abtastfrequenz 5 ermittelt und dann auch kontinuierlich als Abtastfrequenz fuer die weitere Abtastfolge 25 ueber Leitung 81 ausgibt. Euer die Berechnung der weiteren Abtastfrequenz kennt der Rechnerteil 80a somit eine Eingangsabtastfrequenz, eine gewuenschte Ausgangsabtastfrequenz und damit auch ein Abtastintervall wie es der Abstand 26 angibt. Daraus kann der Rechnerteil 80a die weitere Abtastfrequenz berechnen, die zwei Bedingungen erfuellen muss:

a) Das Verhaeltnis von Ausgangsabtastfrequenz oder Eingangsabtastfrequenz zur weiteren Abtastfrequenz soll moeglichst einfach sein und weitgehend dem Verhaeltnis von Eingangsabtastfrequenz zu Ausgangsabtastfrequenz oder umgekehrt entsprechen und

b) die Abweichung zwischen Eingangsabtastfrequenz oder Ausgangsabtastfrequenz und weiterer Abtastfrequenz soll so klein ein, dass ein Abtastwert nicht haeufiger als nach einer vorgegebenen Zeit (z.B. alle Sekunden) fehlt oder ueberfluessig ist, wie dies die Figuren 2 und 3 zeigen.

Wenn nun die Eingangsabtastfrequenz beispielsweise 44,1kHz und die Ausgangsabtastfrequenz 48kHz betraegt, genuegt es nach den obengenannten Bedingungen die Eingangsabtastfrequenz mit 160 zu multiplizieren und anschliessend durch 147 zu teilen. Die weitere Abtastfrequenz darf von der Eingangsabtastfrequenz oder von der Ausgangsabtastfrequenz durchaus abweichen, nur soll die Abweichung genuegend klein sein.

Ist die weitere Abtastfrequenz einmal bekannt, so sind zwei gleichwertige Moeglichkeiten offen. In einer ersten Ausfuehrung werden die Abtastwerte der Eingangsabtastfolge in einer ersten Umwandlung an die weitere Abtastfrequenz angepasst, beispielsweise durch Synchronisation, so dass eine weitere Abtastfolge entsteht und diese wird in einer zweiten Umwandlung in die Ausgangsabtastfolge uebergefuehrt wobei diese Umwandlung bei unterschiedlichen aber festen Abtastraten erfolgt. In einer zweiten Ausfuehrung wird in einer ersten Umwandlung die Eingangsabtastfolge gemaess einem berechneten Abtastratenverhaeltnis in eine weitere Abtastfolge uebergefuehrt und diese anschliessend in einer zweiten Umwandlung an die Ausgangsabtastfrequenz angepasst.

Die erstgenannte Ausfuehrung soll nun genauer betrachtet werden, denn die zweite Ausfuehrung kann sinngemaess leicht davon abgeleitet werden. Ausgehend von der nun bekannten weiteren Abtastfrequenz kann die Synchronisierschaltung 65 die Verarbeitung der Eingangsabtastfolge aufnehmen. In Figur 1 betrachtet, bedeutet dies, dass Eingangsabtastwerte 6 bis 12 so verzoegert werden, dass daraus weitere Abtastwerte 6′ bis 12′ werden. Die Verzoegerungszeiten, die durch die Pfeile 6″ bis 12″ dargestellt sind nehmen in diesem Beispiel mit fortschreitender Zeit, also nach rechts, ab, ohne jedoch eine Grenze 82, die im Prinzip jeder Abtastzeit 4 zugeordnet ist, zu unterschreiten. In Figur 6 betrachtet, bedeutet dies, dass die Eingangsabtastwerte ueber den Einlesezeiger 52 in den Speicher 50 oder 71 eingelesen werden und dass sie, durch die weitere Abtastfrequenz gesteuert, durch den Auslesezeiger 54 ausgelesen werden. So treten sie in den Rechner 72 ein, wo sie die Multipliziereinheit 56, die sie mit Eins multipliziert, und den Addierer 59 der Null dazu addiert, durchlaufen. Denkt man sich, dass dieser Vorgang weiter ablaeuft wobei sich die Pfeile 11″, 12″ und nicht eingezeichnete folgende Pfeile immer weiter verkuerzen, so muss es soweit kommen, dass die Situation gemaess Figur 2 eintritt, wo man erkennt, dass der Eingangsabtastwert 30 schon jenseits der Grenze 82 liegt. Bevor es soweit kommt wird ein weiterer Vorgang eingeleitet, der den Eingangsabtastwert 30 zeitlich gesehen in einen neuen Eingangsabtastwert 30′ umwandelt, der aber an dessen Wert nichts aendert.

Dieser weitere Vorgang ist die Ueberblendung. Dazu gibt es zwei Faelle zu unterscheiden:

1) Die Eingangsabtastfrequenz ist kleiner als die weitere Abtastfrequenz.

2) Die Eingangsabtastfrequenz ist groesser als die weitere Abtastfrequenz.

In Figur 1 ist Fall 1 dargestellt. Es bedeutet, dass der Einlesezeiger 52 sich laufend zum Auslesezeiger 54 hin verschieben muss um die Abtastwerte in den Speicher 50 einzulesen, wenn man annimmt, dass dieser sich im Uhrzeigersinn dreht. Wenn die Zeiger 52, 54 einander nahe genug stehen, ist die Grenze 82 erreicht. Dann beginnt die Ueberblendung. Fuer die Ueberblendung werden den Multipliziereinheiten 55 und 56 Koeffizienten zugefuehrt. In der Darstellung gemaess Figur 8 gelangen diese aus dem Koeffizientengenerator 76 ueber den Bus 77 in den Rechner 72. Das bedeutet auch, dass fuer die Ueberblendung Abtastwerte ueber die beiden Auslesezeiger 53 und 54 aus dem Speicher 50 ausgelesen werden. Die mit diesen Abtastwerten durchgefuehrten Operationen lassen sich mathematisch wie folgt formulieren:

$$y_i = (1 - a_i)x_i + a_i x_{i-1}$$

Dabei werden die mit $x_{i-1}$ bezeichneten Abtastwerte der Multipliziereinheit 55 zugefuehrt und dort mit Koeffizienten $a_i$ multipliziert und die mit $x_i$ bezeichneten Abtastwerte werden der Multipliziereinheit 56 zugefuehrt und dort mit Koeffizienten $(1-a_i)$ multipliziert. Wird eine solche Ueberblendung ueber acht Abtastwerte verteilt durchgefuehrt, so berechnen sich die acht Abtastwerte $c_1$ bis $c_8$ wie folgt, wenn auch noch der vorausgehende und der nachfolgende Wert mitberechnet wird:

$$c_0 = 8/8x_5 + 0/8x_4 = x_5$$
$$c_1 = 7/8x_6 + 1/8x_5$$
$$c_2 = 6/8x_7 + 2/8x_6$$
$$c_3 = 5/8x_8 + 3/8x_7$$
$$c_4 = 4/8x_9 + 4/8x_8 = 1/2(x_8 + x_9)$$
$$c_5 = 3/8x_{10} + 5/8x_9$$
$$c_6 = 2/8x_{11} + 6/8x_{10}$$
$$c_7 = 1/8x_{12} + 7/8x_{11}$$

$$c_8 = 0/8x_{13} + 8/8x_{12} = x_{12}$$
$$c_9 = 8/8x_{13} + 0/8x_{12} = x_{13}$$

Man beachte, dass nach der Berechnung des Abtastwertes $c_8$ die Koeffizienten vertauscht werden, woraus sich auf die gleiche Weise aus den gleichen Abtastwerten ein Abtastwert $c_9$ berechnen laesst. Um diese gleichen Abtastwerte nochmals zu nehmen, werden die Auslesezeiger 53 und 54 gestoppt. Auf diese Weise wird ueber die acht neuen Abtastwerte hinweg ein Abtastwert weggelassen.

Diese Vorgaenge koennen auch mit der Darstellungsweise gemaess Figur 4 verfolgt werden. Auf Zeile 41 erkennt man eine lueckenlose Folge von Eingangsabtastwerten $x_1$ bis $x_{16}$ welche ueber den Auslesezeiger 54 ausgelesen wird. Auf Zeile 42 erkennt man eine verzoegerte Folge von Eingangsabtastwerten $x_0$ bis $x_{15}$, die man erhaelt, wenn man ueber den Auslesezeiger 53 gleichzeitig mit dem Auslesezeiger 54 die Abtastwerte ausliest. Aus Zeile 43 ist ersichtlich, dass der Abtastwert $x_8$ zweimal ausgelesen werden muesste, wenn keine Ueberblendung durchgefuehrt wuerde. Dies waere fuer die Darstellung gemaess Figur 2 auch der Fall. Dort muesste der Abtastwert 28 zweimal ausgelesen werden. Einmal fuer die Abtastzeit 29 und einmal fuer die Abtastzeit 33. In Zeile 44 sind die einzelnen Abtastwerte der neuen Ausgangsabtastfolge nochmals gezeigt.

Der Ueberblendvorgang wird durch die Steuereinheit 80 (Fig. 8) gesteuert. Darin werden Zeitdifferenzen zwischen den Abtastzeitpunkten der Folgen ermittelt, die durch die Abtastfrequenzen gegeben sind, wie sie ueber die Leitungen 68 und 70 eintreffen. Diese Zeitdifferenzen werden beispielsweise nach dem Verfahren und mit einer Vorrichtung ermittelt, wie sie aus der europaeischen Patentschrift Nr. 0084592 bekannt ist. Diese Zeitdifferenz wird anschliessend mit einer vorgegebenen Zeitdiffernz verglichen, die der Grenze 82 entspricht. So wird bestimmt, wann der Ueberblendvorgang eingeleitet wird. Wenn es soweit ist, gehen Signale ueber die Leitung 81 an den Koeffizientengenerator 76 und den Adressgenerator 74, so dass die Produktion der Koeffizienten aufgenommen und allfaellige Adressenspruenge ausgeloest werden.

Im Fall 2 bewegt sich der Einlesezeiger 52 im Gegenuhrzeigersinn relativ gegen den Auslesezeiger 54 hin. Wenn dies nicht mehr so weitergehen kann, ohne einen Konflikt zwischen den Ein- und Auslesepointern zu verursachen, ist eine Ueberblendung faellig. Diese Ueberblendung laesst sich entsprechend in mathematischer Form wie folgt ausdruecken:

$$y_i = a_i x_i + (1 - a_i) x_{i-1}$$

Dabei werden die mit $x_{i-1}$ bezeichneten Abtastwerte der Multipliziereinheit 55 zugefuehrt und dort mit Koeffizienten $1-a_i$ multipliziert und die mit $x_i$ bezeichneten Abtastwerte werden der Multipliziereinheit 56 zugefuehrt und dort mit Koeffizienten $a_i$ multipliziert. Wird eine solche Ueberblendung ueber acht Abtastwerte verteilt durchgefuehrt, so berechnen sich die acht Abtastwerte $c_1$ bis $c_8$ wie folgt, wenn auch noch der vorausgehende und der nachfolgende Wert mitberechnet wird:

$$c_0 = 8/8x_5 + 0/8x_4 = x_5$$
$$c_1 = 7/8x_6 + 1/8x_5$$
$$c_2 = 6/8x_7 + 2/8x_6$$
$$c_3 = 5/8x_8 + 3/8x_7$$
$$c_4 = 4/8x_9 + 4/8x_8 = 1/2(x_8 + x_9)$$
$$c_5 = 3/8x_{10} + 5/8x_9$$
$$c_6 = 2/8x_{11} + 6/8x_{10}$$
$$c_7 = 1/8x_{12} + 7/8x_{11}$$
$$c_8 = 0/8x_{13} + 8/8x_{12} = x_{12}$$
$$c_9 = 8/8x_{14} + 0/8x_{15} = x_{13}$$

Man beachte, dass nach der Berechnung des Abtastwertes $c_8$ die Koeffizienten wiederum vertauscht werden, woraus sich auf die gleiche Weise aus den gleichen Abtastwerten ein Abtastwert $c_9$ berechnen laesst und die Koeffizienten fuer den naechsten Ueberblendvorgang bereitgestellt sind. Man beachte, dass der Abtastwerte $c_8$ aus den Abtastwerten $x_{12}$ und $x_{13}$ ermittelt wird. Um den naechsten Abtastwert $c_9$ mit vertauschten Koeffizienten zu berechnen, muessen aber die Abtastwerte $x_{14}$ und $x_{15}$ verwendet werden. Somit springen die beiden Auslesezeiger 53 und 54 um zwei Abtastwerte weiter statt um einen einzigen Abtastwert wie ueblich.

Auch in diesem Fall koennen die Vorgaenge in der Figur 5 teilweise erkannt werden. Dessen Zeilen 45, 46, 47 entsprechen genau den Zeilen 40, 41 und 42 in Figur 4. In Zeile 48 erkennt man zwischen den Abtastwerten $x_7$ und $x_9$, dass ein Abtastwert fehlt. Dies entspricht dem Sprung, den die Auslesezeiger 53, 54 allerdings erst nach der Ueberblendung ausfuehren.

Fuer die Dimensionierung des Speichers 50, 71 kann man beispielsweise davon ausgehen, dass zwischen den einzelnen Ueberblendvorgaengen auch Perioden ohne Ueberblendung liegen sollen. Der Speicher soll so gross sein, dass er die momentanen Schwankungen der Abtastfrequenzen auffangen kann. Er soll auch so gross sein, dass Ueberblendungen dann nur von Zeit zu Zeit durch nominal unterschiedliche Abtastfrequenzen ausgeloest werden, wenn die Unterschiede der Abtastintervalle sich ueber eine gewisse Zeit aufsummiert haben.

Nachdem nun die weitere Abtastfolge 25 durch die eben beschriebene Anpassung aus der Eingangsabtastfolge erzeugt ist, kann die Umwandlung dieser weiteren Abtastfolge in die Ausgangsabtastfolge 15 erfolgen. Dazu werden die Abtastwerte ueber den Bus 67, 79 dem Abtastratenwandler 66 zugefuehrt. Dort kann die Umwandlung der weiteren Abtastwerte in Ausgangsabtastwerte nach an sich bekannten Prinzipien erfolgen. Solche sind beispielsweise in Schaefer & Rabiner: "A Digital Signal Processing Approach to Interpolation", Proc. IEEE, 61-6, June 1973 beschrieben. Da es hier nun darum geht, synchrone Folgen von Abtastwerten zu wandeln, koennen auch einfachste Prinzipien der Umwandlung angewendet werden, wie z.B. die Umwandlung zwischen festen Verhaeltnissen der Abtastfrequenzen usw.

Bei der zweiten Ausfuehrung erfolgt zuerst die Umwandlung der Eingangsabtastfolge mit einem vorgegebenen Verhaeltnis der Abtastfrequenzen in die weitere Abtastfolge und diese wird anschliessend durch Synchronisation in die Ausgangsabtastfolge umgewandelt, die fast die gleiche Abtastfrequenz hat. Dieses Verfahren kann leicht nachvollzogen werden, indem in Figur 1 die Ausgangsabtastfolge 15 als neue Eingangsabtastfolge und die Eingangsabtastfolge 14 als neue Ausgangsabtastfolge betrachtet wird. Alle Pfeile, inkl. die Zeitachse 1 muessen dann in die andere Richtung weisen. Das vorgegebene Verhaeltnis der Abtastfrequenzen kann auch zeitlich variieren.

## Patentansprüche

1. Verfahren zum Umwandeln der Abtastwerte (6 bis 13) einer Eingangsabtastfolge (14), die mit einer Eingangsabtastfrequenz auftreten, in Abtastwerte (16 bis 24) einer Ausgangsabtastfolge (15), die mit einer Ausgangsabtastfrequenz (3) auftreten, dadurch gekennzeichnet, dass aus der Eingangsabtastfrequenz und der Ausgangsabtastfrequenz (3) eine weitere Abtastfrequenz (5) abgeleitet wird, dass die Abtastwerte (6 bis 13) der Eingangsabtastfolge (14) durch eine erste Umwandlung in Abtastwerte (6′ bis 13′) einer weiteren Abtastfolge (25) mit der weiteren Abtastfrequenz (5) umgesetzt werden, dass durch eine zweite Umwandlung die Abtastwerte (6′ bis 13′) der weiteren Abtastfolge (25) in Abtastwerte der Ausgangsabtastfolge (15) umgesetzt werden und dass fuer die eine der beiden Umwandlungen eine Synchronisation der Abtastfolgen und fuer die andere der beiden Umwandlungen eine Abtastratenwandlung mit einem vorgegebenen Verhaeltnis durchgefuehrt wird.

2. Verfahren nach Anspruch 1, dadurch gekennzeichnet, dass die Eingangsabtastfrequenz und die weitere Abtastfrequenz (5) nur um einen kleinen Betrag ueber eine laengere Zeit voneinander abweichen und sich weitgehend durch die Phasenlage voneinander unterscheiden.

3. Verfahren nach Anspruch 1, dadurch gekennzeichnet, dass die Ausgangsabtastfrequenz (3) und die weitere Abtastfrequenz (5) nur um einen kleinen Betrag voneinander abweichen und sich weitgehend durch die Phasenlage voneinander Unterscheiden.

4. Verfahren nach Anspruch 1, dadurch gekennzeichnet, dass aus Abtastzeiten der Eingangsabtastfolge und Abtastzeiten (4) der weiteren Abtastfolge (25) Zeitdifferenzen (6″ bis 12″) ermittelt werden, dass ein Grenzwert (82) fuer die Zeitdifferenz vorgegeben wird, dass diese Zeitdifferenz mit dem Grenzwert verglichen wird, dass zur Synchronisation Abtastwerte (6 bis 13), die einer Zeitdifferenz (6″bis 13″) zugeordnet sind, die groesser ist als der Grenzwert, zeitlich gesehen gegeneinander verschoben werden, so dass die Zeitdifferenz aufgehoben wird und dass Abtastwerte (30), die einer Zeitdifferenz zugeordnet sind, die kleiner ist als der Grenzwert, durch Ueberblendung in Abtastwerte der weiteren Abtastfolge umgewandelt werden.

5. Verfahren nach Anspruch 4, dadurch gekennzeichnet, dass die Ueberblendung zwischen Abtastwerten der Eingangsabtastfolge (41, 46) und Abtastwerten einer daraus abgeleiteten weiteren Abtastfolge (42, 47) erfolgt.

6. Verfahren nach Anspruch 5, dadurch gekennzeichnet, dass die Abtastwerte der weiteren Abtastfolge durch Verzoegerung der Abtastwerte der Eingangsabtastfolge um ein Abtastintervall gewonnen werden.

7. Verfahren nach Anspruch 1, dadurch gekennzeichnet, dass das vorgegebene Verhaeltnis der Abtastfrequenzen mit der Zeit veraendert und laufend neu berechnet wird.

8. Vorrichtung zur Durchfuehrung des Verfahrens nach Anspruch 1, gekennzeichnet durch eine Synchronisierschaltung (65) die Abtastwerte einer Abtastfolge zu vorgegebenen Abtastzeiten synchronisiert und durch einen Abtastratenwandler (66), der Abtastwerte einer Abtastfolge in Abtastwerte einer Abtastfolge mit anderer Abtastfrequenz umwandelt.

9. Vorrichtung nach Anspruch 8, dadurch gekennzeichnet, dass die Synchronisierschaltung (65) und der Abtastratenwandler (66) in Serie geschaltet sind.

10. Vorrichtung nach Anspruch 8, dadurch gekennzeichnet, dass die Synchronisierschaltung (65) einen Speicher (71), einen Rechner (72) und eine Steuerung (80) enthaelt.

## Claims

1. Method for converting the scanning value (6 to 13) of an input scanning sequence (14) occurring with an input scanning frequency into the scanning values (16 to 24) of an output scanning sequence (15) occurring with an output scanning frequency (3), characterized in that from the input scanning frequency and the output scanning frequency (3) is derived a further scanning frequency (5), that the scanning values (6 to 13) of the input scanning sequence (14) are transformed by a first conversion into scanning values (6′ to 13′) of a further scanning sequence (25) with the further scanning frequency (5), that by a second conversion the scanning values (6′ to 13′) of the further scanning sequence (25) are transformed into scanning values of the output scanning sequence (15) and that for one of the two conversions a synchronization of the scanning sequences is performed and for the other of the two conversions a scanning rate conversion with a predetermined relationship.

2. Method according to claim 1, characterized in that the input scanning frequency and the further scanning frequency (5) only differ from one another by a small amount over a long period of time and largely differ from one another by the phase position.

3. Method according to claim 1, characterized in that the output scanning frequency (3) and the further scanning frequency (5) only differ from one another by a small amount and largely differ by the phase position.

4. Method according to claim 1, characterized in that from the scanning times of the input scanning sequence and scanning times (4) of the further scanning sequence (25) time differences (6″ to 12″) are determined, that a limit value (82) is given for the time difference, that this time difference is compared with the limit value, that for synchronization purposes scanning values (6 to 13) associated with a time difference (6″ to 13″) and which is greater than the limit value are reciprocally displaced from the time standpoint, so that the time difference is eliminated and that scanning values (30) associated with a time difference, which is smaller than the limit value are converted by cross-fading into scanning values of the further scanning sequence.

5. Method according to claim 4, characterized in that cross-fading takes place between the scanning values of the input scanning sequence (41,46) and scanning values of a further scanning sequence (42,47) derived therefrom.

6. Method according to claim 5, characterized in that the scanning values of the further scanning sequence are obtained by delaying the scanning values of the input scanning sequence by a scanning interval.

7. Method according to claim 1, characterized in that the predetermined relationship of the scanning frequencies is varied with time and is continuously recalculated.

8. Apparatus for performing the method according to claim 1, characterized by a sync circuit (65), which synchronizes the scanning values of a scanning sequence at predetermined scanning times and by a scanning rate converter (66), which converts the scanning values of a scanning sequence into scanning values of a scanning sequence with a different scanning frequency.

9. Apparatus according to claim 8, characterized in that the sync circuit (65) and scanning rate converter (66) are connected in series.

10. Apparatus according to claim 8, characterized in that the sync circuit (65) contains a memory (71), a computer (72) and a control (80).

## Revendications

1. Procédé pour convertir des valeurs d'échantillonnage (6 à 13) d'une séquence d'échantillonnage d'entrée (14), qui apparaissent avec une fréquence d'échantillonnage d'entrée, en des valeurs d'échantillonnage (16 à 24) d'une séquence d'échantillonnage de sortie (15), qui apparaissent avec une fréquence d'échantillonnage de sortie (3), caractérisé en ce que l'on dérive une autre fréquence d'échantillonnage (5) à partir de la fréquence d'échantillonnage d'entrée et de la fréquence d'échantillonnage de sortie (3), on convertit les valeurs d'échantillonnage (6 à 13) de la séquence d'échantillonnage d'entrée (14), par une première conversion, en des valeurs d'échantillonnage (6′ à 13′) d'une autre séquence d'échantillonnage (25) ayant l'autre fréquence d'échantillonnage (5), on convertit les valeurs d'échantillonnage (6′ à 13′) de l'autre séquence d'échantillonnage (25), par une seconde conversion, en des valeurs d'échantillonnage de la séquence d'échantillonnage de sortie (15), et on effectue, pour l'une des deux conversions, une synchronisation des séquences d'échantillonnage et, pour l'autre des deux conversions, une conversion de taux d'échantillonnage avec un rapport prédéterminé.

2. Procédé selon la revendication 1, caractérisé en ce que la fréquence d'échantillonnage d'entrée et l'autre fréquence d'échantillonnage (5) s'écartent l'une de l'autre seulement d'une petite valeur pendant un temps long et qu'elles se différencient l'une de l'autre largement par la relation des phases.

3. Procédé selon la revendication 1, caractérisé en ce que la fréquence d'échantillonnage de sortie (3) et l'autre fréquence d'échantillonnage (5) s'écartent l'une de l'autre seulement d'une petite valeur et qu'elles se différencient l'une de l'autre largement par la relation des phases.

4. Procédé selon la revendication 1, caractérisé en ce que l'on détermine des différences de temps (6″ à 12″) à partir de temps d'échantillonnage de la séquence d'échantillonnage d'entrée et à partir de temps d'échantillonnage (4) de l'autre séquence d'échantillonnage (25), on détermine à l'avance une valeur limite (82) pour la différence de temps, on compare cette différence de temps avec la valeur limite, on déplace, pour la synchronisation, les unes par rapport aux autres dans le temps, des valeurs d'échantillonnage (6 à 13) qui sont associées à une différence de temps (6″ à 13″) plus grande que la valeur limite, de telle sorte que la différence de temps est supprimée, et on convertit des valeurs d'échantillonnage (30) qui sont associées à une différence de temps plus petite que la valeur limite, par transfert, en des valeurs d'échantillonnage de l'autre séquence d'échantillonnage.

5. Procédé selon la revendication 4, caractérisé en ce que le transfert est effectué entre des valeurs d'échantillonnage de la séquence d'échantillonnage d'entrée (41, 46) et des valeurs d'échantillonnage d'une autre séquence d'échantillonnage (42, 47) dérivée de la première.

6. Procédé selon la revendication 5, caractérisé en ce que les valeurs d'échantillonnage de l'autre séquence d'échantillonnage sont obtenues par un retardement, égal à un intervalle d'échantillonnage, des valeurs d'échantillonnage de la séquence d'échantillonnage d'entrée.

7. Procédé selon la revendication 1, caractérisé en ce que le rapport prédéterminé des fréquences d'échantillonnage varie dans le temps et est continuellement de nouveau calculé.

8. Dispositif pour la mise en oeuvre du procédé selon la revendication 1, caractérisé en ce que l'on synchronise, au moyen d'un circuit de synchronisation (65), les valeurs d'échantillonnage d'une séquence d'échantillonnage avec des temps prédéterminés d'échantillonnage, et on convertit, au moyen d'un convertisseur de taux d'échantillonnage (66), les valeurs d'échantillonnage d'une séquence d'échantillonnage en des valeurs d'échantillonnage d'une séquence d'échantillonnage ayant une autre fréquence d'échantillonnage.

9. Dispositif selon la revendication 8, caractérisé en ce que le circuit de synchronisation (65) et le convertisseur de taux d'échantillonnage (66) sont branchés en série.

10. Dispositif selon la revendication 8, caractérisé en ce que le circuit de synchronisation (65) contient une mémoire (71), un calculateur (72) et une unité de commande (80).

Fig.1
1
2
3
4
5
6
6'
6"
7
7'
7"
8
8'
8"
9
9'
10
10'
10"
11
11'
11"
12
12'
12"
13
14
15
16
17
18
19
20
21
22
23
24
25
26
27
82
Fig.2
28
29
30
30'
31
32
33
34
82
Fig.3
35
36
37
38

Fig. 4

| 1 | 2 | 3 | 4 | 5 | 6 | 7 | 8 | 9 | 10 | 11 | 12 | 13 | 14 | 15 | 16 | 40 |
|---|---|---|---|---|---|---|---|---|---|---|---|---|---|---|---|---|
| $x_1$ | $x_2$ | $x_3$ | $x_4$ | $x_5$ | $x_6$ | $x_7$ | $x_8$ | $x_9$ | $x_{10}$ | $x_{11}$ | $x_{12}$ | $x_{13}$ | $x_{14}$ | $x_{15}$ | $x_{16}$ | 41 |
| $x_0$ | $x_1$ | $x_2$ | $x_3$ | $x_4$ | $x_5$ | $x_6$ | $x_7$ | $x_8$ | $x_9$ | $x_{10}$ | $x_{11}$ | $x_{12}$ | $x_{13}$ | $x_{14}$ | $x_{15}$ | 42 |
| $x_1$ | $x_2$ | $x_3$ | $x_4$ | $x_5$ | $x_6$ | $x_7$ | $x_8$ | $x_8$ | $x_9$ | $x_{10}$ | $x_{11}$ | $x_{12}$ | $x_{13}$ | $x_{14}$ | $x_{15}$ | 43 |
| $x_1$ | $x_2$ | $x_3$ | $x_4$ | $c_0$ | $c_1$ | $c_2$ | $c_3$ | $c_4$ | $c_5$ | $c_6$ | $c_7$ | $c_8$ | $x_{13}$ | $x_{14}$ | $x_{15}$ | 44 |

Fig. 5

| 1 | 2 | 3 | 4 | 5 | 6 | 7 | 8 | 9 | 10 | 11 | 12 | 13 | 14 | 15 | 16 | 45 |
|---|---|---|---|---|---|---|---|---|---|---|---|---|---|---|---|---|
| $x_1$ | $x_2$ | $x_3$ | $x_4$ | $x_5$ | $x_6$ | $x_7$ | $x_8$ | $x_9$ | $x_{10}$ | $x_{11}$ | $x_{12}$ | $x_{13}$ | $x_{14}$ | $x_{15}$ | $x_{16}$ | 46 |
| $x_0$ | $x_1$ | $x_2$ | $x_3$ | $x_4$ | $x_5$ | $x_6$ | $x_7$ | $x_8$ | $x_9$ | $x_{10}$ | $x_{11}$ | $x_{12}$ | $x_{13}$ | $x_{14}$ | $x_{15}$ | 47 |
| $x_0$ | $x_1$ | $x_2$ | $x_3$ | $x_4$ | $x_5$ | $x_6$ | $x_7$ | $x_9$ | $x_{10}$ | $x_{11}$ | $x_{12}$ | $x_{13}$ | $x_{14}$ | $x_{15}$ | $x_{16}$ | 48 |
| $x_0$ | $x_1$ | $x_2$ | $x_3$ | $c_0$ | $c_1$ | $c_2$ | $c_3$ | $c_4$ | $c_5$ | $c_6$ | $c_7$ | $c_8$ | $x_{14}$ | $x_{15}$ | $x_{16}$ | 49 |

Fig. 6
X4
X5
X3
X6
X2
X7
X1
X8
50
51
52
53
54
55
56
57
58
59
60
71
72
+

Fig.7
62
64
69
66
67
70
65
83
63
68
61
Fig.8
71
72
78
73
79
65
75
77
74
76
68
70
81
80
80a